# EUROPÄISCHE PATENTANMELDUNG

(11) **EP 2 434 853 A1**
(43) Veröffentlichungstag der Anmeldung: **28.03.2012**
(21) Anmeldenummer: 10010196.3
(22) Anmeldetag: 22.09.2010
(51) Int. Cl.: H05K 7/20

(54) **Klimatisierungsvorrichtung zum Kühlen von Luft für einen Elektronikgeräteschrank oder dergleichen**

(71) Anmelder: STULZ GmbH, D-22457 Hamburg (DE)
(72) Erfinder: Sklenak, Bretislav, 84048 Mainburg (DE)
(74) Vertreter: Kossak, Sabine

(57) **Zusammenfassung**

Eine Klimatisierungsvorrichtung (2) zum Kühlen von Luft für einen Elektronikgeräteschrank oder dergleichen weist ein Gehäuse mit einer ersten Seite (8) und einer der ersten Seite (8) gegenüberliegenden zweiten Seite (14) auf, eine Luftfördereinrichtung (10) und einen Wärmetauscher (4). Die Luftfördereinrichtung (10) saugt Luft aus der ersten Seite (8) an, leitet sie durch den Wärmetauscher (4) zu der zweiten Seite (14) und gibt sie in radialer Richtung an der zweiten Seite (14) ab. Der Wärmetauscher (4) steht mit einer externen oder internen Kühleinrichtung zum Beaufschlagen des Wärmetauschers (4) mit gekühltem Kühlmedium in Verbindung. Das erfindungsgemäße Prinzip beruht darauf, dass eine Klimatisierungsvorrichtung 2 eine effektive offene Luftkühlung zum Kühlen von Elektronikgeräten in benachbarten Elektronikgeräteschränken ermöglicht, bei der bedingt durch den sogenannten Coanda-Effekt radial austretende Luftströmung an Frontflächen benachbarter Elektronikgeräteschränke anliegen und dadurch nahezu ohne vorherige Vermischung mit warmer Luft und demnach ohne Wirkungsgradeinbußen von den Elektronikgeräteschränken eingesaugt und zur Kühlung verwendet werden kann.

## Beschreibung

### TECHNISCHES GEBIET

Die Erfindung betrifft eine Klimatisierungsvorrichtung zum Kühlen von Luft für einen Elektronikgeräteschrank oder dergleichen.

### HINTERGRUND DER ERFINDUNG

In Rechenzentren und Fertigungsanlagen werden verbreitet Elektronikgeräte in Elektronikgeräteschränken (auch als "Rack" bekannt) untergebracht, die ein standardisiertes Rastermaß, beispielsweise 19 Zoll, besitzen. Häufig weisen derartige Schränke ausreichend Raum für eine Vielzahl von dicht übereinander gestapelten Elektronikgeräten auf. Neben der Versorgung mit elektrischer Leistung und Daten besteht die Notwendigkeit, die Elektronikgeräte zum Sicherstellen ihres Betriebs ausreichend zu kühlen. Zur Kühlung werden üblicherweise Klimatisierungsvorrichtungen eingesetzt, welche im Wesentlichen zum Bereitstellen von Kühlluft dienen, die mit Hilfe von in den Elektronikgeräten angeordneten Luftfördereinrichtungen durch die Elektronikgeräte geleitet wird und dabei Wärme der elektronischen Komponenten aufnimmt. Mit stärker werdender Konzentration von Rechenleistung pro Raumeinheit besteht ein immer größer werdender Bedarf, möglichst effektive Klimatisierungsvorrichtungen bereitstellen zu können, die zuverlässig und dauerhaft ausreichend kühle Kühlluft in genügender Menge bereitstellen können, ohne dabei einen zu großen Bauraum zu beanspruchen. Üblicherweise sind bekannte Klimatisierungsvorrichtungen mit einfachen Kühlmechanismen ausgestattet, die beispielsweise auf einem Verdampferkühlkreislauf basieren.

In modernen Rechenzentren werden mehrere durch Gänge voneinander beabstandete Reihen bestehend aus zueinander benachbarten Elektronikgeräteschränken in einem Raum angeordnet, wobei Fronten der Elektronikgeräteschränke einer Reihe zu Fronten von Elektronikgeräteschränken einer benachbarten Reihe zeigen können. Die Fronten weisen häufig Lufteinlässe auf, die zum Einsaugen von kühler Luft aus einem sogenannten "kühlen Gang" eingerichtet sind. Die durch die elektronischen Komponenten aufgewärmte Luft gerät an den Rückseiten wieder aus den Elektronikgeräteschränken in einen sogenannten "warmen Gang". Es muss daher mindestens eine Klimatisierungsvorrichtung vorhanden sein, die kühle Luft in die kalten Gänge leitet, beispielsweise heruntergekühlte Luft aus warmen Gängen. Es ist bekannt, über Bodenauslässe kalte Luft in einen kühlen Gang einzublasen. Ebenfalls bekannt ist es, Klimatisierungsvorrichtungen zwischen den Elektronikgeräteschränken anzuordnen, wobei die kalte Luft aus den Klimagerät senkrecht zur Front der benachbarten Elektronikgeräteschränke eingeblasen wird.Bei diesem Konzept handelt sich um ein offenes Luftkühlungskonzept.

Ebenfalls bekannt sind geschlossenen Architekturen. Dabei befindet sich ein Elektronikgeräteschrank und eine derartige Klimatisierungsvorrichtung in einer abgeschlossenen Umhüllung bzw. einem gemeinsamen Gehäuse.

Nachteilig bei Klimatisierungsvorrichtungen aus dem Stand der Technik ist anzusehen, dass die durch die Klimatisierungsvorrichtungen gekühlte Luft bei einem offenen Luftkühlungskonzept nicht ideal zu den zu kühlenden Elektronikgeräten geleitet wird. Die bereitgestellte Kühlluft vermischt sich bei Verwendung der bekannten Auslässe mit erwärmter Luft, bevor sie letztendlich an den Fronten der Elektronikgeräteschränke zur Kühlung der Elektronikgeräte eingesaugt werden kann.

### ZUSAMMENFASSUNG DER ERFINDUNG

Es ist daher als eine Aufgabe der Erfindung anzusehen, eine Klimatisierungsvorrichtung gemäß der eingangs genannten Art vorzuschlagen, die die oben genannten Nachteile verringern oder gänzlich eliminieren kann. Insbesondere ist es als eine Aufgabe der Erfindung anzusehen, eine Klimatisierungsvorrichtung vorzuschlagen, die zwar als eigenständige, unabhängige Einheit ausgeführt ist, jedoch besonders effektiv gekühlte Luft zu Elektronikgeräteschränken leitet, so dass die bereitgestellte Kühlluft möglichst direkt von den einzelnen Elektronikgeräten zur Kühlung aufgenommen werden kann.

Diese Aufgabe wird gelöst durch eine Klimatisierungsvorrichtung mit den Merkmalen des unabhängigen Anspruchs 1. Vorteilhafte Weiterbildungen sind den Unteransprüchen zu entnehmen.

Gemäß einem ersten Aspekt der Erfindung weist die erfindungsgemäße Klimatisierungsvorrichtung ein Gehäuse mit einer ersten Seite und einer zweiten Seite auf und ist dazu eingerichtet, an der ersten Seite Luft anzusaugen und an der zweiten Seite gekühlt auszublasen. Die erste Seite und die zweite Seite der erfindungsgemäßen Klimatisierungsvorrichtung sind dabei einander gegenüberliegend angeordnet, so dass sich die erfindungsgemäße Klimatisierungsvorrichtung zwischen Elektronikgeräteschränken anordnen lässt und an ihrer zweiten Seite Kühlluft für die Verwendung in Elektronikgeräteschränken bereitstellt. Dies bietet sich besonders bei einem offenen Luftkühlkonzept mit warmen und kalten Gängen zwischen einander gegenüberliegenden Reihen von Elektronikgeräteschränken an.

Gemäß einem zweiten Aspekt der Erfindung weist die zweite Seite der erfindungsgemäße Klimatisierungsvorrichtung eine Luftfördereinrichtung auf, die die Kühlluft in radialer Richtung nach außen ausleitet. Die radiale Richtung ist dabei als eine im Wesentlichen senkrechte Richtung zu einer Achse zwischen der ersten Seite und der zweiten Seite zu verstehen. An der ersten Seite findet demnach eine axiale Lufteinströmung in die erfindungsgemäße Klimatisierungsvorrichtung statt, die zu einer radial gerichteten Luftausströmung auf der zweiten Seite führt.

Gemäß einem dritten Aspekt der Erfindung befindet sich zwischen der ersten Seite und der zweiten Seite der erfindungsgemäßen Klimatisierungsvorrichtung eine Kühleinrichtung, die die axial einströmende Luft kühlt, bevor sie die Klimatisierungsvorrichtung wieder in radialer Richtung verlässt.

Im Wesentlichen kann damit die erfindungsgemäße Klimatisierungsvorrichtung einen Kühlluftstrom für ein offenes Luftkühlkonzept bereitstellen. Für eine besonders effektive Luftausströmung, die zu einer idealen Aufnahme durch benachbarte Elektronikgeräte führt, ist die Tiefe der erfindungsgemäßen Klimatisierungsvorrichtung bevorzugt so angepasst, dass sich die Luftfördereinrichtung oder ein Luftauslassbereich der erfindungsgemäßen Klimatisierungsvorrichtung über die Fronten von benachbarten Elektronikgeräteschränken hinaus erstreckt oder dass sich die Luftfördereinrichtung an der zweiten Seite der erfindungsgemäßen Klimatisierungsvorrichtung so von einer Frontenebene von benachbarten Elektronikgeräteschränken in axialer Richtung erstreckt, dass die Radialströmung direkt parallel und in einem vernachlässigbaren Abstand entlang von Fronten der benachbarten Elektronikgeräteschränke verläuft. Hierbei ist besonders vorteilhaft anzusehen, dass der austretende Kühlluftstrom die Tendenz aufweist, sich an den Oberflächen der benachbarten Elektronikgeräteschränkefronten entlang zu bewegen und sich an die Oberflächen anzulegen, anstatt sich abzulösen, um sich in der ursprünglich aufgeprägten Strömungsrichtung weiter zu bewegen. Der Effekt des Anlegens einer Strömung ist nach dessen Entdecker Henri Coanda als Coanda-Effekt bekannt. Aufgrund dieser anliegenden Strömung ist der radial austretende Kühlluftstrom nicht frei in den mehrere Elektronikgeräteschränke aufweisenden Raum gerichtet, wo er sich mit warmer Luft vermischen kann, sondern die zu der erfindungsgemäßen Klimatisierungsvorrichtung benachbarten Elektronikgeräteschränke werden unmittelbar mit einem Strom kalter Luft beispielsweise an deren Fronten beaufschlagt, so dass entsprechende Luftfördereinrichtungen in den Elektronikgeräteschränken unmittelbar nahezu ausschließlich reine Kühlluft aufnehmen und zur Kühlung der Elektronikgeräte verwenden können.

Trotz der Realisierung eines offenen Luftkühlkonzepts mit einer unabhängig und eigenständig ausgeführten Klimatisierungsvorrichtung ist die Effektivität der erfindungsgemäßen Klimatisierungsvorrichtung gegenüber bekannten Klimatisierungsvorrichtungen deutlich erhöht, da die eingesetzte Kühlleistung nicht gegen stetige Verluste durch die Vermischung mit warmer Luft arbeiten muss, sondern nahezu die vollständige, von der Klimatisierungsvorrichtung bereitgestellte Kühlleistung die zu kühlenden Elektronikgeräten erreichen kann.

Ein weiterer besonderer Vorteil der Bauweise der erfindungsgemäßen Klimatisierungsvorrichtung liegt darin, dass ein Kühlsystem mit mehreren Klimatisierungsvorrichtungen sehr leicht skaliert werden kann, da beispielsweise benachbart zu örtlich sehr hohen Wärmelasten (sogenannte "hot spots") besonders leicht zusätzliche erfindungsgemäße Klimatisierungsvorrichtungen angeordnet werden können, die außerdem direkt zusätzliche Kühlluft bereitstellen können, ohne Modifikationen an Elektronikgeräteträgern zu erfordern.

In einer vorteilhaften Ausführungsform der Erfindung ist die Luftfördereinrichtung als ein Radialgebläse ausgeführt, welches sich von der zweiten Seite der erfindungsgemäßen Klimatisierungsvorrichtung nach außen hin erstreckt, und eine axial in die Klimatisierungsvorrichtung eintretende Luftströmung in radialer Richtung parallel zu einer Begrenzungsfläche der zweiten Seite ausleitet.

Bevorzugt ist die Drehzahl der Luftfördereinrichtung und damit der erreichte Luftvolumenstrom regelbar, so dass die Kühlleistung individuell abgerufen und den zu kühlenden Geräten bereitgestellt werden kann. Besonders eignen sich bürstenlose Gleichstrommotoren zum Antrieb von Gebläsen, da diese besonders effektiv sind und auch unter Volllastbedingungen einen hohen Wirkungsgrad erzielen.

Besonders bevorzugt weist die erfindungsgemäße Klimatisierungseinrichtung mindestens einen Temperatursensor auf, der derart positioniert ist, dass er die Temperatur der ausströmenden Kühlluft oder der einströmenden erwärmten Luft erfasst. Hierdurch wird eine Regelgröße für die Regelung der Drehzahl der Luftfördereinrichtung und/oder der Kühlleistung realisiert.

In einer vorteilhaften Weiterbildung weist die erfindungsgemäße Klimatisierungsvorrichtung mindestens eine Schnittstelle für mindestens einen Temperatursensor auf, der sich an einem benachbarten und zu kühlenden Gerät befindet. Die auf der Rückseite eines benachbarten zu kühlenden Geräts, typischerweise ein Elektronikgeräteschrank bzw. ein Elektronikgerät in einem Elektronikgeräteschrank, gemessene Temperatur kann zur Regelung des Luftvolumenstroms und/oder des Wärmetauschers verwendet werden. Durch eine Rückkopplung einer in einem benachbarten Gerät gemessenen Temperatur könnte beispielsweise bei der Kühlung besonders leistungsstarker Geräte auch verhindert werden, dass die zur Verfügung stehende Kühlleistung nicht ausreicht.

In einer vorteilhaften Ausführungsform der Erfindung sind mehrere Radialgebläse über die zweite Seite verteilt an der erfindungsgemäßen Klimatisierungsvorrichtung angeordnet, so dass über die gesamte Bauhöhe der erfindungsgemäßen Klimatisierungsvorrichtung ein möglichst gleichmäßiger radialer Luftstrom entsteht. Zusätzlich kann bevorzugt jedes einzelne dieser Radialgebläse über die Bauhöhe eine individuelle Zuluft- bzw. Rücklufttemperaturregelung mittels individueller Drehzahlregelung bzw. Regelung des verursachten Luftvolumenstroms realisieren, um auf individuelle Kühlanforderungen reagieren zu können. Hierfür könnten über die Höhe der erfindungsgemäßen Klimatisierungsvorrichtung mehrere Temperatursensoren platziert werden, damit eine individuelle Anpassung an die Kühlanforderungen über die Bauhöhe gewährleistet werden kann. In einer besonders vorteilhaften Ausführungsform weist der Wärmetauscher mehrere Wärmetauschersegmente auf, so dass zu jedem Radialgebläse ein eigenes für sich regelbares Wärmetauschersegment gehört. So kann nicht nur der Luftvolumenstrom jedes Radialgebläses individuell geregelt werden, sondern auch das jeweils dazugehörige Wärmetauschersegment.

In einer vorteilhaften Ausführungsform der Erfindung weist die Klimatisierungsvorrichtung an der zweiten Seite einen vorspringenden Rahmen auf, in dem die Luftfördereinrichtung angeordnet ist. Dies dient zum Schutz vor mechanischen Schäden an der Luftfördereinrichtung, da diese aufgrund der erfindungsgemäßen Ausgestaltung von einer einheitlichen Frontenebene benachbarter Elektronikgeräteschränke absteht und damit für versehentliche Schäden exponiert ist. Bevorzugt weist dieser vorspringende Rahmen eine Gitterverkleidung auf, die ein seitliches Ausströmen von Kühlluft ermöglichen.

Gemäß einer vorteilhaften Ausführungsform der Erfindung weist die Klimatisierungsvorrichtung Leitelemente auf, die zur definierten Ausrichtung und Harmonisierung der ausströmenden Kühlluft dienen. Diese könnten beispielsweise in einem vorangehend genannten vorspringenden Rahmen angeordnet werden, etwa an dessen Seitenflächen. Die Leitelemente könnten ferner dazu verwendet werden, das radiale Ausleiten von Kühlluft an einer Seite der erfindungsgemäßen Klimatisierungsvorrichtung gänzlich einzustellen, falls etwa nur auf einer einzigen Seite der Klimatisierungsvorrichtung ein Elektronikgeräteschrank angeordnet ist.

Gemäß einer vorteilhaften Ausführungsform der Erfindung können derartige Leitelemente so ausgerichtet werden, dass der Coanda-Effekt möglichst ideal einzutreten vermag, beispielsweise durch eine stärkere Bündelung der austretenden Luftströmung oder durch eine Anpassung an etwaige Krümmungen von Fronten benachbarter Elektronikgeräteschränke.

Gemäß einer vorteilhaften Ausführungsform der Erfindung weist die Klimatisierungsvorrichtung eine Kühleinrichtung auf, die eintretende warme Luft kühlen kann. Die Kühleinrichtung kann sowohl eine eigenständige Vorrichtung zum aktiven Erzeugen von Kälte sein, die beispielsweise direkt innerhalb der erfindungsgemäßen Kühlvorrichtung angeordnet ist. Alternativ dazu könnte die Kühlvorrichtung auch lediglich als ein Wärmetauscher ausgeführt sein, der mit einem an anderer Stelle zentral gekühlten Kühlmedium beaufschlagt wird, um hindurchtretende warme Luft zu kühlen.

Vorteilhaft wäre weiterhin, bei Verwendung einer aktiven Kühleinrichtung diese mit drehzahlgeregelten Kompressoren auszustatten. Dies erlaubt eine Regelung der Kühlleistung, wodurch sich die Energiekosten reduzieren und die Energieeffizienz der Geräte weiter steigern lässt. Durch die Verwendung von bürstenlosen Gleichstrommotoren wird auch unter Volllastbedingungen ein sehr hoher Wirkungsgrad erzielt.

Die Regelung der Gebläsedrehzahlen und der Kompressoren könnte über eine einzige, zentrale Regeleinheit realisiert werden, die über eine Bedieneinheit kontrolliert und beeinflusst werden könnte. Die Regeleinheit könnte dabei die Höhe einer Spannung zum Betreiben der zu regelnden Komponenten einstellen, alternativ dazu eine Frequenz der Spannung, oder weiter alternativ eine Regelgröße ausgeben, die von dezentralen Regeleinheiten in oder an den zu regelnden Komponenten mit Istgrößen zur Regelung verglichen werden.

### KURZE BESCHREIBUNG DER FIGUREN

Weitere Merkmale, Vorteile und Anwendungsmöglichkeiten der vorliegenden Erfindung ergeben sich aus der nachfolgenden Beschreibung der Ausführungsbeispiele und den Figuren. Dabei bilden alle beschriebenen und/oder bildlich dargestellten Merkmale für sich und in beliebiger Kombination den Gegenstand der Erfindung, auch unabhängig von ihrer Zusammensetzung in einzelnen Ansprüchen oder deren Rückbeziehungen. In den Figuren stehen weiterhin gleiche Bezugszeichen für gleiche oder ähnliche Objekte.
Figuren 1a), 1b), 1c), 1d), 1e) und 1f) zeigen ein erstes Ausführungsbeispiel der erfindungsgemäßen Klimatisierungsvorrichtung.
Figuren 2a), 2b), 2c), 2d), 2e) und 2f) zeigen ein zweites Ausführungsbeispiel der erfindungsgemäßen Klimatisierungsvorrichtung.
Figuren 3a), 3b), 3c) und 3d) zeigen die erfindungsgemäße Klimatisierungsvorrichtung in einer Prinzipdarstellung, wobei die Figur 3d) die erfindungsgemäße Klimatisierungsvorrichtung in einem eingebauten Zustand zeigt.

### DETAILIERTE DARSTELLUNG EXEMPLARISCHER AUSFÜHRUNGSFORMEN

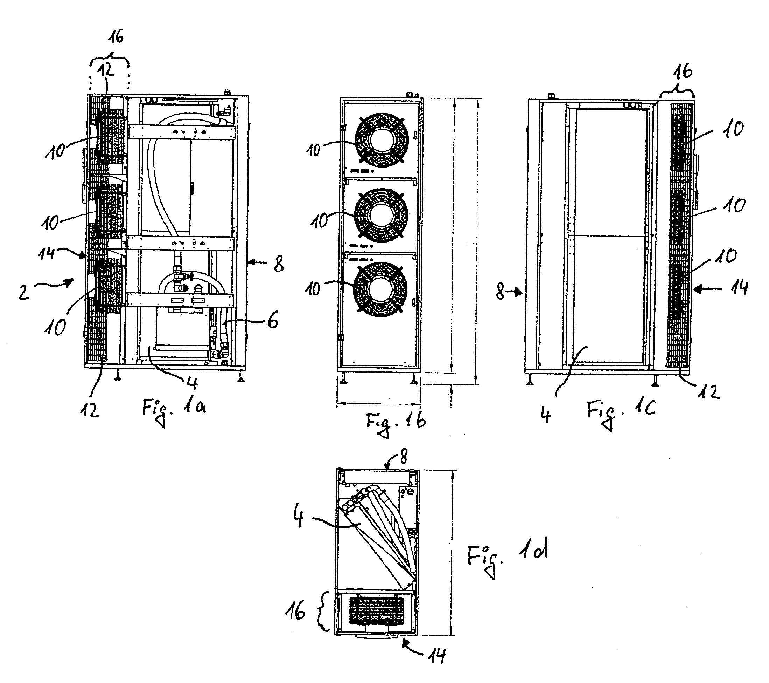

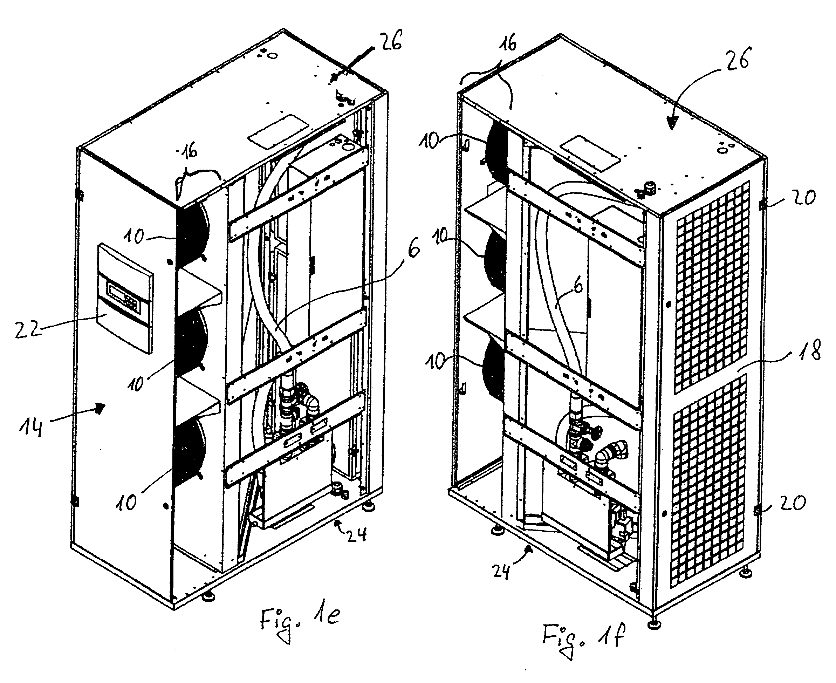

Figur 1a) zeigt eine erfindungsgemäße Klimatisierungsvorrichtung 2 in einer ersten Seitenansicht. Die Klimatisierungsvorrichtung 2 umfasst einen Luft-Flüssigkeits-Wärmetauscher 4, der über Leitungen 6 mit einer nicht dargestellten zentralen Kühleinheit zum Fördern eines gekühlten Kühlmediums verbunden ist. Luft, die von einer ersten Seite 8, die sich in der Darstellung auf der rechten Seite befindet und die Rückseite der erfindungsgemäßen Klimatisierungsvorrichtung 2 darstellt, wird mittels Radialgebläsen 10 als Luftfördereinrichtungen in die Klimatisierungsvorrichtung 2 gesogen, strömt an dem mit dem Kühlmedium beaufschlagten Wärmetauscher 4 vorbei, wird dadurch gekühlt und verlässt die Klimatisierungsvorrichtung 2 durch Öffnungen 12 in einer Seitenwand der erfindungsgemäßen Klimatisierungsvorrichtung 2. Dies bedeutet, dass Luft auf die erste Seite 8 der erfindungsgemäßen Klimatisierungsvorrichtung 2 strömt, gekühlt wird, dabei in Richtung einer zweiten Seite 14 der erfindungsgemäßen Klimatisierungsvorrichtung 2 strömt, dort von Radialgebläsen 10 im Wesentlichen um 90° umgelenkt wird und radial, d.h. im Wesentlichen parallel zu der Erstreckungsrichtung der zweiten Seite 14, wieder aus der Klimatisierungsvorrichtung 2 strömt.

Die Öffnungen 12 könnten in Form eines Gitters mit Gitteröffnungen realisiert werden, das einen Teil der erfindungsgemäßen Klimatisierungsvorrichtung 2 verkleidet, um beispielsweise die Gebläse 10 vor Beschädigungen zu schützen.

Die erfindungsgemäße Klimatisierungsvorrichtung 2 ist derart ausgestaltet, dass sie bevorzugt zwischen oder neben Elektronikgeräteschränken eingebaut werden kann, so dass sich ein vorderer Auslassbereich 16 mit seitlichen Öffnungen 12 deutlich von den Fronten der Elektronikgeräteschränke in den Raum erstreckt, so dass die aus den Gittern 12 ausströmende Luft an den Fronten der Elektronikgeräteschränke entlangstreichen und sich dort anlegen kann. Durch die Eigenständigkeit der erfindungsgemäßen Klimatisierungsvorrichtung müssen weiterhin an benachbarten Elektronikgeräteschränken keine Modifikationen vorgenommen werden, um eine besonders effektive Kühlung zu realisieren.

Die Vorderansicht der erfindungsgemäßen Klimatisierungsvorrichtung 2 aus Figur 1b) stellt anschaulich dar, dass auf einer relativ geringen Breite eine besonders vorteilhafte Kühlung für benachbarte Elektronikgeräteschränke erreicht werden kann. Die erfindungsgemäße Klimatisierungsvorrichtung 2 beansprucht im Vergleich zu üblichen Elektronikgeräteschränken eine recht geringe Breite.

Die Darstellung aus Figur 1c) lässt erkennen, dass der Wärmetauscher 4 schräg innerhalb der erfindungsgemäßen Klimatisierungsvorrichtung 2 angeordnet ist, so dass durchstreichende Luft eine relativ große Oberfläche des Wärmetauschers 4 durchströmen kann.
Weiterhin zeigt Figur 1d) in einer Draufsicht die aus den Figuren 1a) bis 1c) ersichtlichen Komponenten der erfindungsgemäßen Klimatisierungsvorrichtung, wobei hier besonders deutlich wird, dass der Wärmetauscher 4 schräg, d.h. winklig zu einer Achse zwischen der ersten Seite 8 und der zweiten Seite 14 angeordnet ist. Die aktive Fläche des Wärmetauschers 4 kann durch diese besonders gute Ausnutzung des zur Verfügung stehenden Volumens maximiert werden.

Schließlich zeigen die Figuren 1e) und 1f) das erste Ausführungsbeispiel der erfindungsgemäßen Klimatisierungsvorrichtung 2 in zwei unterschiedlichen isometrischen Ansichten. Der Übersichtlichkeit halber ist das Gitter 12 entfernt und lässt einen freien Blick auf die Gebläse 10 zu. Ebenfalls zum Schutz vor Beschädigungen und Verschmutzung ist die erste Seite 8 mit einem Einlaufgitter 18 verkleidet, das beispielsweise an Scharnieren 20 aufgehängt sein könnte, um einen Zugriff auf die Leitungen 6 und andere Komponenten der Klimatisierungsvorrichtung zu erlauben. Schließlich ist zur Steuerung der erfindungsgemäßen Klimatisierungsvorrichtung 2 eine Bedieneinheit 22 an der zweiten Seite 14 angeordnet, die beispielsweise eine Ventilanordnung der Leitungen 6 regeln kann, um das Durchströmen eines Kühlmediums und damit die Kühlleistung individuell auf den entsprechenden Bedarf einzustellen.

Die Leitungen 6 münden exemplarisch in einem Boden 24 und ragen bis zu einem oberen Deckel 26, so dass Anschlussleitungen ober- oder unterhalb der erfindungsgemäßen Klimatisierungsvorrichtung 2 verwendet werden können.

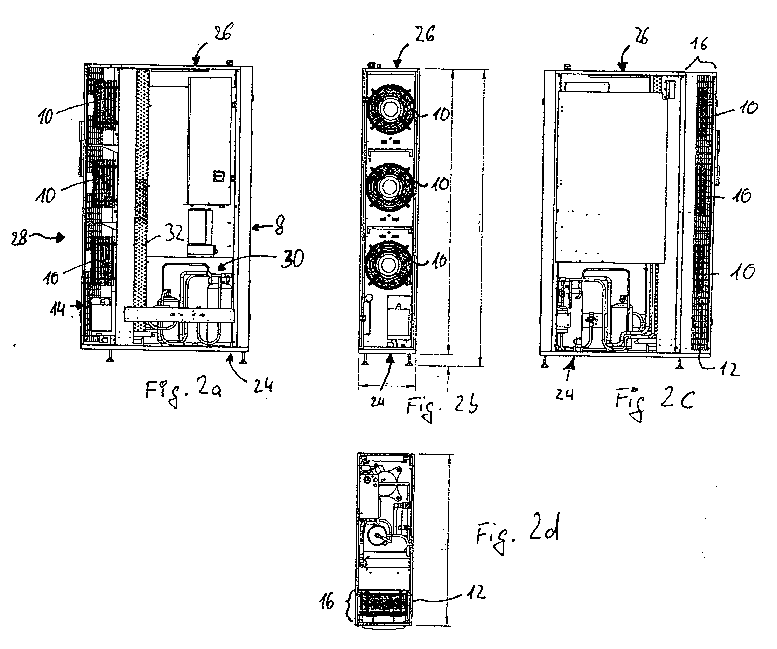

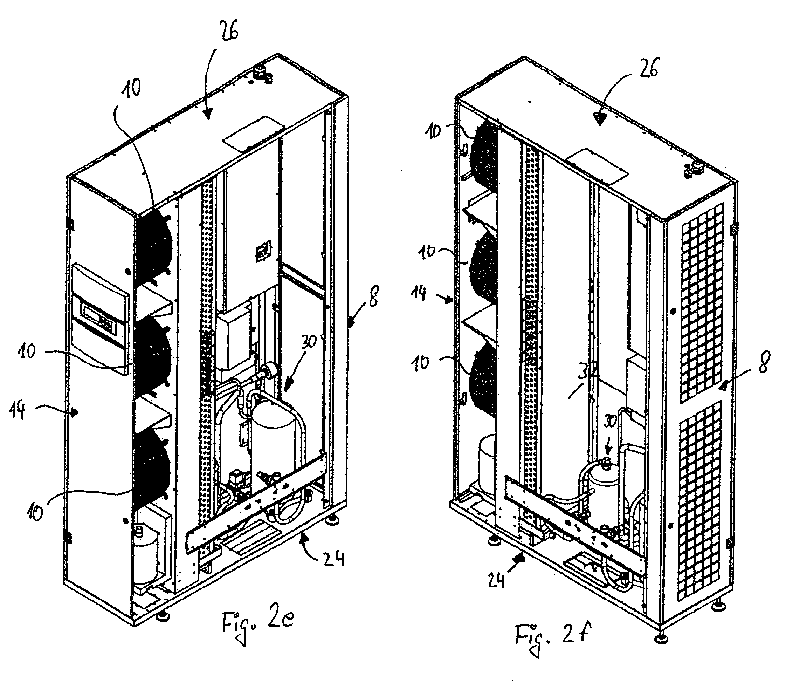

In den Figuren 2a) bis 2f) wird ein zweites Ausführungsbeispiel einer erfindungsgemäßen Klimatisierungsvorrichtung 28 gezeigt, dass sich im Wesentlichen dadurch von der erfindungsgemäßen Klimatisierungsvorrichtung 2 des ersten Ausführungsbeispiels unterscheidet, dass eine kompakte, aktive Kühleinrichtung 30 integriert ist.

Dies ist besonders vorteilhaft für kleinere Rechenzentren oder alleinstehende Elektronikgeräteschränke etwa in Fertigungsumgebungen vorteilhaft, wenn eine zentrale Kühlanlage zum Versorgen von Wärmetauschern mit gekühltem Kühlmedium wirtschaftlich nicht sinnvoll ist. Die hier lediglich schematisch gezeigte Kühleinrichtung 30 könnte beispielsweise auf einem aus Kühlschränken bekannten VerdampferKühlkreislauf basieren. Ein Luft-Flüssigkeits-Wärmetauscher 32 wird mit einer von der Kühleinrichtung 30 gekühlten Flüssigkeit beaufschlagt, so dass eine von der ersten Seite 8 zu der zweiten Seite 14 hin verlaufende Luftströmung eine Kühlung erfährt. Der Luft-Flüssigkeits-Wärmetauscher 32 könnte wie gezeigt aus Platzgründen nicht schräg innerhalb der erfindungsgemäßen Klimatisierungsvorrichtung 28 angeordnet sein, da die Kühleinrichtung 30 den für eine schräge Anordnung benötigten Bauraum belegen könnte, was jedoch durch eine etwas größere Tiefe des Luft-Flüssigkeits-Wärmetauschers 32 ausgeglichen werden kann.

Das zweite Ausführungsbeispiel der erfindungsgemäßen Klimatisierungsvorrichtung 28 kann jedoch ebenfalls eine im Vergleich zur üblichen Elektronikgeräteschränken relativ geringe Breite aufweist, wie in Figur 2b) ersichtlich wird.

Schließlich zeigen die Figuren 2e) und 2f) das zweite Ausführungsbeispiel der erfindungsgemäßen Klimatisierungsvorrichtung 28 in zwei unterschiedlichen isometrischen Ansichten, die einen Einblick in den inneren Aufbau ermöglichen.

Wie vorangehend beschrieben, basiert das erfindungsgemäße Prinzip darauf, dass eine erfindungsgemäße Klimatisierungsvorrichtung 2 bzw. 28 eine offene Luftkühlung zum Kühlen von Elektronikgeräten in benachbarten Elektronikgeräteschränken ermöglicht, dabei jedoch die aus dem Stand der Technik bekannten Nachteile zu eliminieren vermag. Dies kann dadurch erfolgen, dass ein Auslassbereich 16 einer erfindungsgemäßen Klimatisierungsvorrichtung 2 bzw. 28 vor die Fronten von benachbarten Elektronikgeräteschränken springt und gekühlte Luft radial entlang der Fronten dieser benachbarten Elektronikgeräteschränke ausbläst. Direkt an den Fronten der Elektronikgeräteschränke strömt Kühlluft vorbei, die lediglich in die betreffenden Elektronikgeräteschränke eingesaugt werden muss, um eine Kühlung zu erreichen. Erfindungsgemäß bedient sich dieses Prinzip des Coanda-Effekts, der das Anliegen einer Strömung an Flächen beschreibt.

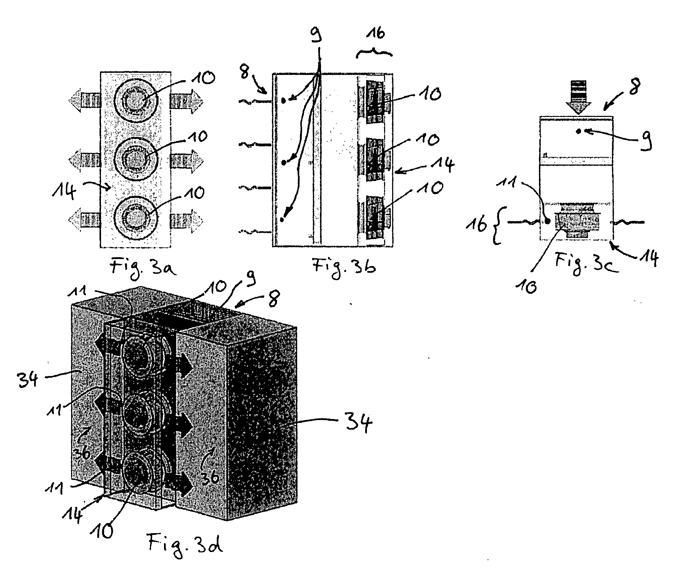

Anhand der Figuren 3a bis 3d wird dieses Prinzip weiter verdeutlicht. Die Figuren 3a bis 3c zeigen die Ausführungsbeispiele der erfindungsgemäßen Klimatisierungsvorrichtung 2 bzw. 28 in einer schematisierten Ansicht. Die erste Seite 8, d. h. die Rückseite der erfindungsgemäßen Klimatisierungsvorrichtung 2 bzw. 28, ist zu einem sogenannten "warmen Gang" mit verbrauchter, aufgewärmter Kühlluft gerichtet, wohingegen die zweite Seite 14, d. h. die Vorderseite, zu einem "kalten Gang" mit frischer gekühlter Kühlluft gerichtet ist. Optional kann die Temperatur der einströmenden Luft mit Hilfe von Temperatursensoren 9 gemessen werden, um eine bedarfsgerechte Regelung der Drehzahl der Radialgebläse 10 zu ermöglichen. In Fig. 3b sind mehrere Temperatursensoren 9 dargestellt, die über die Bauhöhe der erfindungsgemäßen Klimatisierungsvorrichtung 2 verteilt sind und damit eine individuelle Anpassung der Drehzahlen aller Radialgebläse erlauben. Alternativ oder zusätzlich hierzu wäre auch denkbar, einen oder mehrere Temperatursensoren an der Austrittsseite des Wärmetauschers anzuordnen. Besonders vorteilhaft ist es, Temperatursensoren an der Rückseite der zu kühlenden benachbarten Elektronikgeräteschränke auf verschiedenen Höhen anzuordnen und die dort gemessenen Temperaturdaten zu verwenden, die Drehzahlen der Radialgebläse 10 gemeinsam oder individuell zu regeln und/oder - wenn es vorteilhafterweise zu jedem Ventilator ein eigenes für sich regelbares Wärmetauschersegment gibt - auch die Wärmetauschersegmenten individuell zu regeln.

In Figur 3d wird schließlich eine erfindungsgemäße Klimatisierungsvorrichtung 2 bzw. 28 zwischen zwei Elektronikgeräteschränken 34 gezeigt, an deren Fronten 36 kalte Luft aus Radialgebläsen 10 entlang streicht und sich aufgrund des Coanda-Effekts an die Fronten legt.

Die Ausführungsbeispiele der erfindungsgemäßen Klimatisierungsvorrichtungen sind aufgrund des Coanda-Effekts der radial ausgeleiteten Kühlluft besonders effizient. Es sei an dieser Stelle darauf hingewiesen, dass die erfindungsgemäße Klimatisierungsvorrichtung nicht auf die gezeigten Ausführungsbeispiele zu beschränken ist. Vielmehr ist jede denkbare Variation der technischen Ausführung mit mehr oder weniger über- oder nebeneinander angeordneten Luftfördereinrichtungen, unterschiedlichen internen oder externen Kühleinrichtungen, Ausführungen von Wärmetauschern und strömungsmechanischen Details Gegenstand der Erfindung.

## Patentansprüche

1. Klimatisierungsvorrichtung (2, 28) zum Kühlen von Luft für einen Elektronikgeräteschrank oder dergleichen, aufweisend
- ein Gehäuse mit einer ersten Seite (8) und einer der ersten Seite (8) gegenüberliegenden zweiten Seite (14),
- eine Luftfördereinrichtung (10) und
- einen Wärmetauscher (4, 32),
wobei die Luftfördereinrichtung (10) Luft aus der ersten Seite (8) ansaugt, durch den Wärmetauscher (4, 32) zu der zweiten Seite (14) leitet und in radialer Richtung an der zweiten Seite (14) abgibt,
wobei der Wärmetauscher (4, 32) mit einer externen Kühleinrichtung oder einer internen Kühleinrichtung (30) zum Beaufschlagen des Wärmetauschers (4, 32) mit gekühltem Kühlmedium in Verbindung steht.

2. Klimatisierungsvorrichtung (2, 28) nach Anspruch 1, wobei
- die Luftfördereinrichtung (10) als ein Radialgebläse ausgeführt ist, welches sich von der zweiten Seite (14) der erfindungsgemäßen Klimatisierungsvorrichtung (2, 28) nach außen hin erstreckt und
- das dazu eingerichtet ist, eine axial in die Klimatisierungsvorrichtung (2, 28) eintretende Luftströmung in radialer Richtung parallel zu einer Begrenzungsfläche der zweiten Seite (14) auszuleiten.

3. Klimatisierungsvorrichtung (2, 28) nach Anspruch 1 oder 2, aufweisend mehrere zueinander beabstandete auf verschiedenen Höhen angeordnete Luftfördereinrichtungen (10).

4. Klimatisierungsvorrichtung (2, 28) nach Anspruch 3, wobei der Wärmetauscher mehrere jeweils individuell regelbare Wärmetauschersegmente auf verschiedenen Höhen aufweist.

5. Klimatisierungsvorrichtung (2, 28) nach einem der vorhergehenden Ansprüche,
ferner aufweisend einen vorspringenden Rahmen, in dem die Luftfördereinrichtung (10) angeordnet ist.

6. Klimatisierungsvorrichtung (2, 28) nach einem der vorhergehenden Ansprüche, ferner aufweisend eine interne Kühleinrichtung (30).

7. Klimatisierungsvorrichtung (2, 28) nach einem der vorhergehenden Ansprüche, ferner aufweisend mindestens eine Leitung (6) zum Verbinden des Wärmetauschers (4, 32) mit einer zentralen Kühleinrichtung.

8. Klimatisierungsvorrichtung (2, 28) nach einem der vorhergehenden Ansprüche, bei der der durch die Luftfördereinrichtung (10) verursachte Luftvolumenstrom regelbar ist.

9. Klimatisierungsvorrichtung (2, 28) nach Anspruch 3, bei der der verursachte Luftvolumenstrom jeder Luftfördereinrichtung (10) individuell regelbar ist.

10. Klimatisierungsvorrichtung (2, 28) nach Anspruch 8 oder 9, ferner aufweisend mindestens einen Temperatursensor (9, 11) zum Erfassen einer Temperatur einströmender und/oder ausströmender Luft an der Rückseite eines zu kühlenden Elektronikgeräteschranks, an der Rückseite der Klimatisierungsvorrichtung oder an der Austrittseite des Wärmetauschers.

11. Klimatisierungsvorrichtung (2, 28) nach Anspruch 10, aufweisend mehrere Temperatursensoren, die auf verschiedenen Höhen die Temperaturen erfassen und die erfassten Temperaturen zur individuelle Regelung der Luftvolumenströme und/oder der Wärmetauschersegmente verwenden.
